Europäisches Patentamt

European Patent Office

Office européen des brevets

(11) Publication number: **0 536 729 A1**

# EUROPEAN PATENT APPLICATION

(21) Application number: **92117135.1**

(22) Date of filing: **07.10.92**

(51) Int. Cl.⁵: **C04B 35/00**, C01G 29/00

(30) Priority: **08.10.91 JP 260145/91**

(43) Date of publication of application:
**14.04.93 Bulletin 93/15**

(84) Designated Contracting States:
**DE FR GB**

(71) Applicant: **INTERNATIONAL SUPERCONDUCTIVITY TECHNOLOGY CENTER**
**No. 34-3, Shinbashi 5-chome, Minato-ku Tokyo 105(JP)**
Applicant: **THE TOKYO ELECTRIC POWER CO., INC.**
**1-3, 1-chome, Uchisaiwai-cho Chiyoda-ku, Tokyo 100(JP)**
Applicant: **NISSAN MOTOR CO., LTD.**
**2 Takara-cho, Kanagawa-ku Yokohama-shi Kanagawa-ken 221(JP)**
Applicant: **MITSUBISHI DENKI KABUSHIKI KAISHA**
**2-2-3, Marunouchi Chiyoda-ku Tokyo(JP)**

(72) Inventor: **Wakata, Mitsunobu, c/o**
**Superconductivity Res. Lab.**
**Int. Supercond. Techn. Ctr, 14-3 Shinonome 1-chome**
**Koto-ku, Tokyo 135(JP)**
Inventor: **Takano, Satoshi, c/o**
**Superconductivity Res. Lab.**
**Int. Supercond. Techn. Ctr, 14-3 Shinonome 1-chome**
**Koto-ku, Tokyo 135(JP)**
Inventor: **Munakata, Fumio, c/o**
**Superconductivity Res. Lab.**
**Int. Supercond. Techn. Ctr, 14-3 Shinonome 1-chome**
**Koto-ku, Tokyo 135(JP)**
Inventor: **Yamauchi, Hisao, c/o**
**Superconductivity Res. Lab.**
**Int. Supercond. Techn. Ctr, 14-3 Shinonome 1-chome**
**Koto-ku, Tokyo 135(JP)**

(74) Representative: **Bühling, Gerhard, Dipl.-Chem. et al**
**Patentanwaltsbüro Tiedtke-Bühling-Kinne & Partner, Bavariaring 4**
**W-8000 München 2 (DE)**

(54) **Oxide superconducting material.**

(57) According to the present invention, there is provided an oxide superconducting material represented by the following general formula (1):

$$Bi_2 Sr_{2-x} La_x Ca_{1-y} M_y Cu_2 O_q \qquad (1)$$

(wherein M is at least one of rare earth metals except Sc, La, Ce and Pr; $0.1 \leq x + y \leq 0.4$ and $x \geq 0$, $y \geq 0$; $8.1 \leq q \leq 8.4$). The superconducting material of the present invention is applicable at a higher temperature and at a higher magnetic field.

F I G. 1

## BACKGROUND OF THE INVENTION

### Field of the Invention

The present invention relates to an oxide superconducting material of $Bi_2(Sr, Ca)_3 CU_2 O_q$ which is used in a higher magnetic field primarily including superconducting magnets.

### Prior Art

Due to not only the higher critical temperature (Tc) but also the critical magnetic field ($Bc_2$) and critical current density (Jc) both essentially high enough, oxide superconducting materials have been expected of their application to the wire materials (coil materials) for superconducting magnets, power lead (a component to connect a superconducting magnet with a power supply) and the like. For such utilities, a higher Jc is demanded at a higher magnetic field for long-size and large-area superconducting materials in their entirety.

However, polycrystalline oxide superconducting materials have problems in that the Jc which can flow in its entire sample is low and the dependency thereof on magnetic field and temperature is great (Jc rapidly decreases as magnetic field and temperature get higher). This is because (1) the Jc which can pass through the crystalline particles in the entire sample ($Jc^{inter}$) is far lower than the Jc which can flow within the crystalline particles ($Jc^{intra}$) (weak bonding) and (2) the pinning strength for a magnetic flux quantized in the samples, via the heterogeneous points (pinning center) inside the crystalline particles, is weak (weak pinning strength) which strength determines the Jc in a higher magnetic field.

For $YBa_2 Cu_3 O_{7-q}$ materials having Tc around 90 K, alternatively, the technique to disperse non-superconducting deposits such as $Y_2 BaCuO_5$ and the like within the crystal particles has been developed through the improvement of melting process, so that the problem of weak pinning strength is greatly improved to achieve a sufficiently high $Jc^{intra}$ at the temperature of liquid nitrogen (77 K) and in a magnetic field of several T(tesla)s. However, the dispersion technique of non-superconducting deposits has an action rather to deteriorate (lower) $Jc^{inter}$ from the respect of the problem of weak bonding. This would be because the non-superconducting particles also deposits at the border of the crystalline particles.

Through the development of the technique to orient the crystalline axis of each crystalline particle in $Bi_2(Sr, Ca)_3 Cu_2 O_q$ oxide superconducting materials, alternatively, the problem of weak bonding has been improved distinctively. That is, there are mainly present in the materials two superconducting phases of $Bi_2 Sr_2 CaCu_2 O_{8+q}$ (2212 (derived from atomic ratios of Bi, Sr, Ca and Cu) phase) of Tc $\simeq$ 80 K and $Bi_2 Sr_2 Ca_2 Cu_3 O_{10+q}$ (2223 phase) of Tc $\simeq$ 110 K. Herein, it has been difficult to obtain a single phase (phase without impurities) of the latter, but as is known, the substitution of a part of Bi with Pb enables the easy production of a pure superconducting material of Tc > 105 K.

For these two Bi materials, there has been developed a method for preparing a dense and tape-shaped sintered product with accurate arrangement of the C axis of the crystalline particles in the vertical direction of the surface, via the repetition of uniaxial press and re-sintering thermal treatment, or the semi-melting thermal treatment at the interface of Ag, whereby the problem of weak bonding has distinctively been improved. In 2223 phase, Jc exceeding $10^8$ A/cm$^2$ to a 1-T magnetic field in the direction vertical to the C axis is obtained at 77 K.

In Bi 2223 phase, however, the deterioration of Jc is great in a magnetic field exceeding the above intensity, and the anisotropy of Jc to the direction of a magnetic field is high (the deterioration of Jc is great to a magnetic field parallel to C axis). Therefore, the practical application to superconducting magnets is considered difficult at 77 K, because not only the magnetic field vertical to the C axis is applied in actual superconducting magnets.

In case of Bi 2212 phase, alternatively, the property of a higher Jc has been obtained at lower temperatures rather than in 2212 phase. As shown by H. Kumakura, et al. (Appl. Phys. Lett., Vol. 58 (1991), p. 2830), for example, Jc over $10^9$ A/m$^2$ has been reported at 4.2 K even in a magnetic field above 20T. Therefore, it has been considered certain that there will be a superconducting magnet capable of generating a magnetic field above 20 T under 4.2 K.

Herein, the atomic ratio of Sr and Ca in 2212 phase is not limited to 2:1, and it has been known that a pure phase can be generated up to 1:1. Thus, the representation as $Bi_2(Sr, Ca)_3 Cu_2 O_q$ is also possible.

Because oxide superconducting materials have higher Tc, the possibility of the application at a higher temperature has been under investigation. If such application is possible under cooling in liquid nitrogen (20 K), not only the cooling cost can be cut but also the reliability of the cooling system is also improved remarkably.

However, tape-shaped materials of Bi 2212 phase having excellent Jc property at 4.2 K exhibit more dependencies from of magnetic field and temperature at a temperature higher than 20 K. The anisotropy to the direction of magnetic field also becomes greater under this temperature. This is due to the weak pinning strength described above.

## SUMMARY OF THE INVENTION

The present invention has been made so as to solve such problems and to provide an oxide superconducting material applicable at a higher temperature and a higher magnetic field.

The oxide superconducting material of the present invention is the one represented by the following general formula (1):

$$Bi_2 Sr_{2-x} La_x Ca_{1-y} M_y Cu_2 O_q \qquad (1)$$

(wherein M is at least one of rare earth metals except for Sc, La, Ce and Pr; $0.1 \leq x + y \leq 0.4$ and $x \geq 0$, $y \geq 0$; $8.1 \leq q \leq 8.4$.

In the superconducting material of the present invention, the pinning strength of Bi 2212 superconducting material is enhanced so that the desired superconducting material can be achieved.

## BRIEF DESCRIPTION OF THE DRAWING

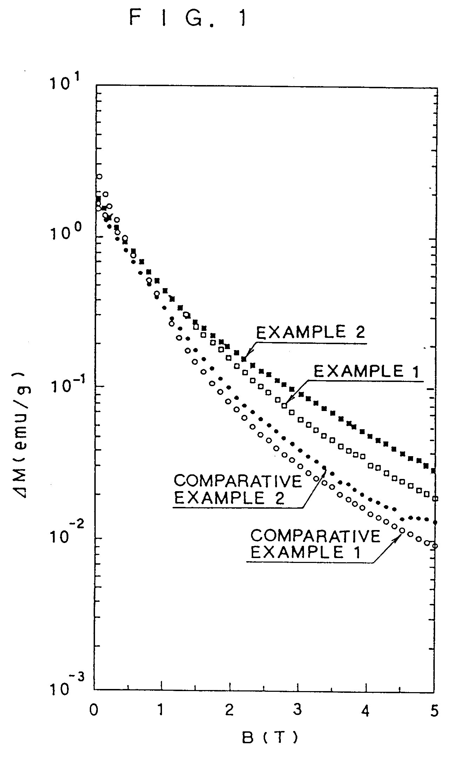

Fig. 1 is a graph depicting the dependency of magnetization hysteresis ($\Delta M$) of an oxide superconducting material on magnetic field (B) at 20 K according to one embodiment of the present invention.

## DETAILED DESCRIPTION OF THE PREFERRED EMBODIMENTS

⟨Examples 1 - 2⟩

As raw materials, $Bi_2O_3$, $SrCo_3$, $CaCO_3$, $CuO$, and oxides of rare earth metals were employed. The powders thereof were weighed so as to obtain a sample with the composition of the general formula (1), followed by thorough mixing by ball milling. The atomic ratios x and y in described above are $0 \leq x \leq 0.5$ and $0 \leq y \leq 0.5$ as shown in Table 1 below, such that $x = 0.2$ and $y = 0$ in Example 1 and $x = 0$ and $y = 0.2$ in Example 2. The mixed powder with each composition was press molded at a pressure of 600 $kgf/cm^2$, and calcined at 790°C for 10 hours. Then, the power was ground. The process consisting of press molding, calcination and grinding was repeated three times. The resulting calcined powder was molded at a pressure of 1,000 $kgf/cm^2$, and sintered in air at 860°C for 30 hours. The structure of the resulting sintered product was analyzed by powder X-ray diffraction analysis and the oxygen content was determined by a coulometric titration. Both of the critical temperature (the temperature wherein a diamagnetism is initiated; $Tc^{on}$) and the size of magnetization hysteresis ($\Delta M$) in proportion to average critical current density (Jc) were evaluated with SQUID (superconducting quantum interference device) magnetrometer, a device for measuring magnetization ratio.

It is known that partly substituting trivalent metals for divalent metals of Sr and Ca decreases carrier (in this case, hole) density. In case of sintering in air (containing oxygen), the increase in the substitution amount for Sr and Ca initially raises Tc. Tc reaches the peak when the substitution amount for Sr and Ca becomes about 0.2, and then decreases. However, a similar Tc change occurs when the oxygen content is lowered. Therefore, in case of changing the substitution amount for Sr and Ca, the change in the pinning strength via the substitution for Sr and Ca cannot be evaluated in a simple manner because Tc also changes when the Sr and Ca substitution amount changes. In other words, the change in the pinning strength may possibly be due to the Tc change, namely, the change in the oxygen content q as another factor to change Tc.

Therefore, there were measured magnetization curves of four samples, i.e., of the sample obtained by sintering a Bi 2212 material in air without any substitution for Sr and Ca (Comparative Example 1), a sample obtained by sintering the same material of Comparative Example 1 in $N_2$ atomosphere (Comparative Example 2) in addition to Examples 1 and 2.

The oxygen contents and $Tc^{on}$ of these four samples are shown in Table 1.

4

Table 1

| Oxygen content and $Tc^{on}$ of samples | | |
|---|---|---|
| | Composition | $Tc^{on}(K)$ |
| Example 1 | $Bi_2 Sr_{1.8} La_{0.2} Ca_1 Cu_2 O_{8.337}$ | 90 |
| Example 2 | $Bi_2 Sr_2 Ca_{0.8} Y_{0.2} Cu_2 O_{8.341}$ | 90 |
| Comparative Example 1 | $Bi_2 Sr_2 CaCu_2 O_{8.284}$ | 76 |
| Comparative Example 2 | $Bi_2 Sr_2 CaCu_2 O_{8.154}$ | 87 |

All the samples were obtained pure and in a tetragonal phase according to the X-ray analysis.

Fig. 1 is a characteristic chart depicting the magnetic field (B) dependency of magnetization hysteresis ($\Delta M$) of the four samples shown in Table 1, at 20 K. Comparing the data of the two samples without substitution (Comparative Examples 1 and 2), $\Delta M$ of Comparative Example 1 is higher at lower magnetic fields while the one of Comparative Example 2 is higher at higher magnetic fields.

This is possibly because Comparative Example 1 has a higher carrier density and Comparative Example 2 has higher Tc, with the result that Comparative Example 2 has a higher critical magnetic field ($Bc_2$). However, such $\Delta M$ difference is small although the difference in Tc is as large as 10 K. On the other hand, Examples 1 and 2 show almost no difference from the cases of no substitution for Sr and Ca (Comparative Examples 1 and 2) at lower magnetic fields. However, at higher material fields, they show a property two times or more as high as the Comparative Example 1. Namely, $\Delta M$ in Examples 1 and 2 does not decrease as much as Comparative Examples, because the decrease in Jc is small at higher magnetic fields. Therefore, the change in the oxygen content has almost no influence on the pinning property, so that it can be said that the partial substitution of trivalent metals for Sr or Ca site with trivalent metals improves the pinning strength.

⟨Examples 3 - 13⟩

The magnetization properties at 20 K of samples with the Ca site substituted by various rare earth metals with $y = 0.2$ (sintered in air) were normalized by the values for the non-doped sample sintered in nitrogen. These magnetization values are shown in Table 2 (which includes those with the Sr site substituted). The oxygen contents (q) of these samples were not accurately measured, so are not described herein. However, such oxygen contents may be nearly at the same degree as in the preceding Example 2. Table 2 herein includes a sample substituted with Pr (Comparative Example 3). However, because Pr easily takes an ionic valency of $+4$, the ionic radius is not shown, which means that this sample is handled in a different manner from the ones with other atoms having $+3$ ionic valency. Furthermore, because La in Examples 12 and 13 is substituent atom for Sr and they cause different properties for the samples, the ionic radii thereof are not shown.

Table 2

| | Composition and magnetization hysteresis of samples | | | | |
|---|---|---|---|---|---|
| | Composition | Ionic radius (A°) ($M^{3+}$) | $\Delta M[Air]/\Delta M[CE2^{***}]$ | | |
| | | | 1T | 3T | 5T |
| Example 3 | $Bi_2Sr_2Ca_{0.8}Nd_{0.2}$ | 1.109 | 1.21 | 1.43 | 1.39 |
| 4 | $Bi_2Sr_2Ca_{0.8}Dy_{0.2}$ | 1.027 | 1.57 | 2.07 | 1.51 |
| 5 | $Bi_2Sr_2Ca_{0.8}H_{0.2}$ | 1.015 | 1.72 | 2.39 | 1.55 |
| 6 | $Bi_2Sr_2Ca_{0.8}Y_{0.2}$ | 1.019 | 1.55 | 2.02 | 2.49 |
| 7 | $Bi_2Sr_2Ca_{0.8}Yb_{0.2}$ | 0.985 | 1.64 | 2.45 | 2.98 |
| 8 | $Bi_2Sr_2Ca_{0.8}Lu_{0.2}$ | 0.977 | 1.80 | 2.31 | 2.48 |
| 9 | $Bi_2Sr_2Ca_{0.8}Gd_{0.1}Dy_{0.1}$ | 1.040* (0.026)** | 1.60 | 2.06 | 2.47 |
| 10 | $Bi_2Sr_2Ca_{0.8}Sm_{0.1}Er_{0.1}$ | 1.42* (0.075)** | 1.81 | 2.40 | 2.42 |
| 11 | $Bi_2Sr_2Ca_{0.8}Gd_{0.1}Lu_{0.1}$ | 1.015* (0.076)** | 2.06 | 2.98 | 2.96 |
| 12 | $Bi_2Sr_2Ca_{0.8}La_{0.2}$ | - | 1.42 | 1.70 | 1.67 |
| 13 | $Bi_2Sr_2Ca_{0.8}La_{0.1}Y_{0.1}$ | - | 1.86 | 2.80 | 2.74 |
| Comparative Example 3 | $Bi_2Sr_2Ca_{0.8}Pr_{0.2}$ | - | 0.20 | 0.16 | 0.14 |

\* The ionic radius of each of Examples 9 to 11 is the mean ionic radius of two species of atoms.

\*\* The numerical figures in brackets show the difference between two species of $M^{3+}$.

\*\*\* Compatative Example 2

In case of M = Pr, its ionic valency tends to take +4, resulting in the carrier density decreasing too much. Thus, Tc decreases too much. Further the magnetization property deteriorates. The same result was confirmed for Ce.

In case of other rare earth metals, the magnetization property was improved by about two times ($\Delta M$-[Air]/$\Delta M$[Comparative Example 2]>2). The rare earth metals having ionic radii smaller than that of Ca (1.12 angstroms) has higher magnetization property, and the effect on improving the property gets enhanced particularly at a higher magnetic field.

Therefore, the elemental substitution for (Sr, Ca) site which causes the distortion of crystalline lattice seems to be related to the pinning strength.

Thus, analysis was done about the samples in which site 10 at. % of each of two rare earth elements were substituted for 20 at. % of the Ca (Examples 9 through 11). Generally, the effect of improving the magnetization property was observed to get larger, when two elements were used for substitution and when the difference in ionic radius of the two elements is large even if the average ionic radii of the substituting elements were constant.

Such effect can also be observed in comparison of Example 13 in which La is substituted for Sr with x = 0.1 and Y is substituted for Ca with y = 0.1 and Example 12 in which La is substituted for Sr with x = 0.2. As shown in Table 2, the magnetization property of Example 13 is higher than the property of each of Example 12 and Example 6 having Y in common (however, y = 0.2).

As has been described above, it is indicated that substituting a rare earth metal except Sc, Ce, and Pr, for (Sr, Ca) site in $Bi_2(Sr, Ca)_3Cu_2O_q$ oxide superconducting material, is effective for enhancing the pinning strength to improve Jc and the dependency thereof on magnetic field and temperature. Further, in substituting rare earth metals for (Sr, Ca) site, substituting two or more trivalent ions with different ionic radius, in particular, is found highly effective. the substitution amount in total (x + y) is effective in a range of 0.1 to 0.4. If it is less than 0.1, the effect of improving Jc is small, while if more than 0.4, the Jc property is rather deteriorated via the distinctive decrease of Tc.

According to the present invention, the pinning strength of Bi 2212 phase can be enhanced, and thus, it is indicated that the critical current density and its dependency on temperature and magnetic field can be improved distinctively. It is thereby possible that conventional superconducting magnets designed to generate a magnetic field of e.g. 3.5 T at 20 K can be reconstructed to generate a magnetic field of about 5 T although they are of the same size. Furthermore, it is also possible that a superconducting magnet of the same size as that of a conventionally designed superconductive magnet to generate a magnetic field of 5 T at 15 K generates a magnetic field of 5 T at 20 K.

In accordance with the present invention, as has been described above, there is provided a superconducting material which can be used at a higher temperature and at a higher magnetic field.

According to the present invention, there is provided an oxide superconducting material represented by the following general formula (1):

$$Bi_2 Sr_{2-x} La_x Ca_{1-y} M_y Cu_2 O_q \qquad (1)$$

(wherein M is at least one of rare earth metals except Sc, La, Ce and Pr; $0.1 \leqq x + y \leqq 0.4$ and $x \geqq 0$, $y \geqq 0$; $8.1 \leqq q \leqq 8.4$). The superconducting material of the present invention is applicable at a higher temperature and at a higher magnetic field.

**Claims**

1. An oxide superconducting material represented by the following general formula (1):

$$Bi_2 Sr_{2-x} La_x Ca_{1-y} M_y Cu_2 O_q \qquad (1)$$

(wherein M is at least one of rare earth metals except Sc, La, Ce and Pr; $0.1 \leqq x + y \leqq 0.4$ and $x \geqq 0$, $y \geqq 0$; $8.1 \leqq q \leqq 8.4$).

F I G. 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | APPL. PHYS. LETT. vol. 56, no. 5, 29 January 1990, pages 487 - 489 , XP000128481 P. SOMASUNDARAM ET AL. --- | 1 | C04B35/00 C01G29/00 |
| X | PHYSICA C vol. 171, no. 3-4, 1 November 1990, pages 315 - 320 R. YOSHIZAKI ET AL. --- | 1 | |
| X | SUPERCOND. SCI. TECHNOL. vol. 3, no. 5, May 1990, pages 242 - 248 C.N.R. RAO ET AL. ----- | 1 | |

TECHNICAL FIELDS SEARCHED (Int. Cl.5)

C04B
C01G

The present search report has been drawn up for all claims

| Place of search | Date of completion of the search | Examiner |
|---|---|---|
| THE HAGUE | 19 JANUARY 1993 | LUETHE H. |

EPO FORM 1503 03.82 (P0401)